# EUROPEAN PATENT SPECIFICATION

(11) **EP 3 166 783 B1**
(45) Date of publication and mention of the grant of the patent: **22.06.2022**
(21) Application number: 15745626.0
(22) Date of filing: 09.07.2015
(51) Int. Cl.: B32B 5/00, B32B 5/02, B32B 5/28, B32B 7/00, B32B 7/04, B32B 7/10, B32B 15/00, B32B 15/04, B32B 15/08, B32B 15/20, B32B 27/00, B32B 27/06, B32B 27/08, B32B 27/20, B32B 27/26, B32B 27/28, B32B 27/30, B32B 27/36, B32B 27/38, B32B 3/00, B32B 3/02

(54) **THIN RESIN FILMS AND THEIR USE IN LAYUPS**
DÜNNE KUNSTHARZFOLIEN UND DEREN VERWENDUNG IN LAYUPS
FILMS MINCES DE RÉSINE ET LEUR UTILISATION DANS DES EMPILEMENTS

(30) Priority: 10.07.2014 US 201462023154 P
(43) Date of publication of application: 17.05.2017
(73) Proprietor: Isola USA Corp., Chandler AZ 85226 (US)
(72) Inventor: SCHUMACHER, Johann, Richard, Gilbert, AZ 85296 (US)
(74) Representative: Haseltine Lake Kempner LLP
(86) International application number: PCT/US2015/039698
(87) International publication number: WO 2016/007718

(56) References cited:
- EP-A1- 1 602 683
- WO-A1-2013/008178
- WO-A2-00/07219
- CA-A1- 2 296 112
- DE-A1- 3 536 883
- JP-A- H10 337 809

## Description

### BACKGROUND OF THE INVENTION

### (1) Field of the Invention

This invention concerns resin film products that are useful in the manufacture of layups used to manufacture printed circuit boards and comprise a partially cured b-staged resin film that has a thickness in the range of about 1 mils to about 10 mils and that is disposed between two protective layers, as well as methods for their manufacture and use.

### (2) Description of the Prior Art

As the demand for electronic devices increases, the speed of manufacture of these devices must also increase. In order to increase the speed of manufacture, the steps in the production must be efficient. Most electronic devices include small, intricate circuit boards that require detailed attention during the manufacturing process. The manufacturing process for producing circuit boards is made particularly difficult due to the use of thin resin laminates. In particular, it is essential that these resin laminates remain free of contaminants and fill all gaps between circuit board components such that the circuit boards are void free. Further, the resin laminates must be cured at a time-sensitive stage during the manufacturing process. As a result, there exists a continuing need for printed circuit board products and methods that improve the speed and efficiency of the manufacturing process.

WO00/07219 describes a high density printed circuit substrate and method of fabrication and describes an example with a resin laminate which may be sandwiched between two removable layers. CA2296112, DE3536883 and JPH10337809 describe other examples of PCB fabrication and WO2013/008178 describes a composite for ballistic protection.

### SUMMARY OF THE INVENTION

In a first aspect, the disclosure provides a resin film product comprising a b-staged resin base layer having a first planar surface and a second planar surface, a first protective layer disposed on the first planar surface of the base layer, and a second protective layer disposed on the second planar surface of the base layer, wherein the base layer has a thickness of about 25.4 µm (1 mil) to 254 µm (10 mils) and wherein the first protective layer and the second protective layer are comprised of a biaxially oriented polyethylene terephthalate with a thickness of 25.4 µm (1 mil) to 127 µm (5 mils) and are configured to be separable from the base layer.

Another aspect of this invention is a method for manufacturing a resin film product comprising the steps of: providing a resin film product according to the first aspect; heating an exposed innerlayer material surface of a printed circuit board substrate; removing the second protective layer from the second planar surface of the base layer; applying the second planar surface of the base layer against the heated exposed innerlayer material surface of the printed circuit board substrate to form a printed circuit board layup; and cooling the printed circuit board layup.

### DESCRIPTION OF THE FIGURES

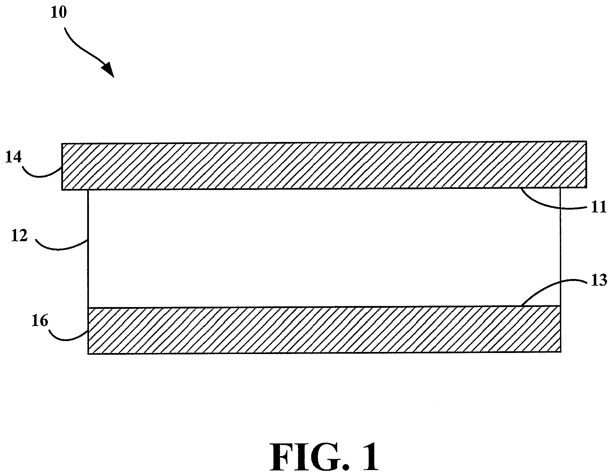

Figure 1 is a side view of a resin film product (10) according to an exemplary embodiment that includes a base layer containing a partially cured, b-staged resin film (12), with a first planar surface (11) and a second planar surface (13), disposed between a first protective layer (14) and a second protective layer (16).

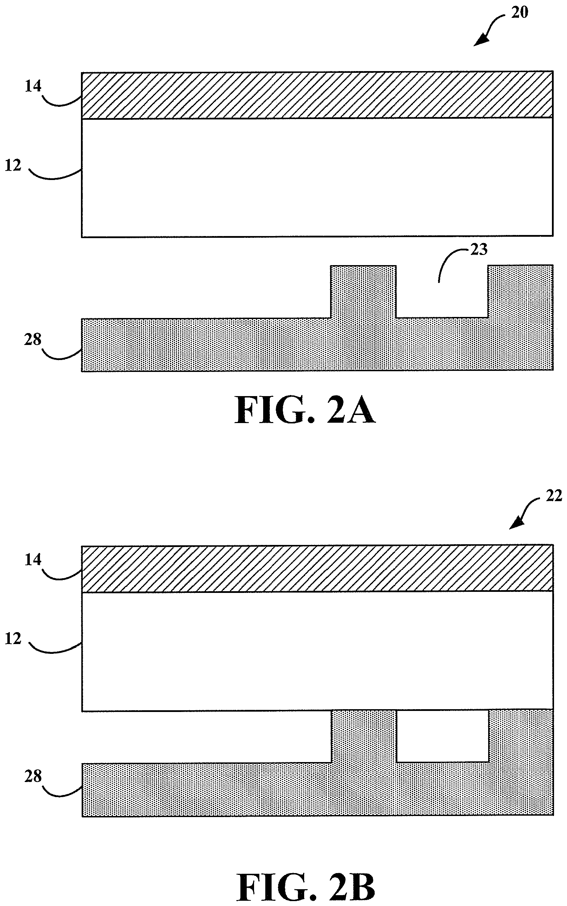

Figure 2A is a side view of a layup (20) according to an exemplary embodiment that includes a resin film product with a base layer (12) and a first protective layer (14) and an innerlayer material surface of a printed circuit board substrate (28) that includes gap or via (23);
Figure 2B is a side view of a layup (22) according to an exemplary embodiment that includes a resin film product with a base layer (12) and a first protective layer (14) and an innerlayer material surface of a printed circuit board substrate (28), where the base layer (12) is applied to the innerlayer material surface;

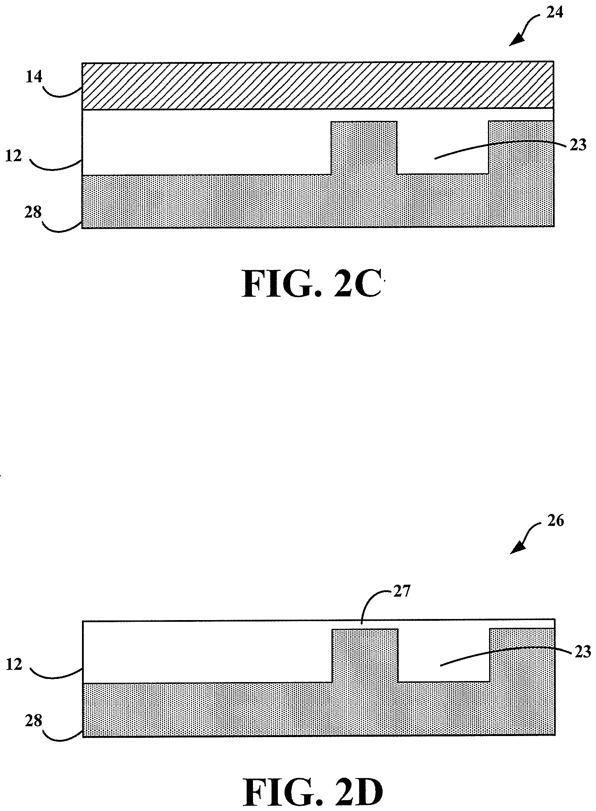

Figure 2C is a side view of a layup (24) according to an exemplary embodiment that includes a resin film product, with a base layer (12) and a first protective layer (14), and an innerlayer material surface of a printed circuit board substrate (28), where the innerlayer material surface is heated to allow the base layer (12) to fill in the gaps (23) located on the innerlayer material surface;
Figure 2D is a side view of a layup (26) according to an exemplary embodiment that includes a resin film product with a base layer (12) and an innerlayer material surface of a printed circuit board substrate (28), where the first protective layer has been removed, the gaps (23) located on the innerlayer material are filled by the base layer (12), a "butter layer" (27) separates the innerlayer material of the printed circuit board substrate (28) from the top planar surface of the base layer (12), and the layup (26) has been cooled and the base layer (12) subsequently cured;

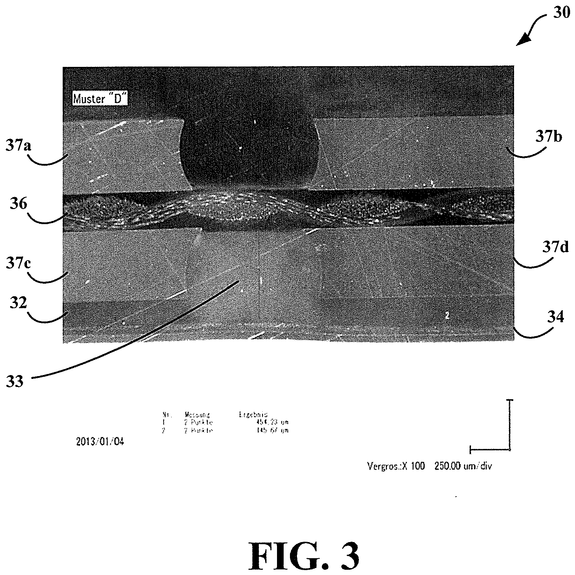

Figure 3 is a side cutaway view of a printed circuit board substrate (30) according to an exemplary embodiment including a base layer (32) being used to fill a via (33) between copper tracks (37a, 37b, 37c, 37d), an innerlayer material (36) in the form of glass reinforced epoxy core material, and a protective layer (34) in the form of a reinforced fabric pre-impregnated with a resin system ("prepreg");

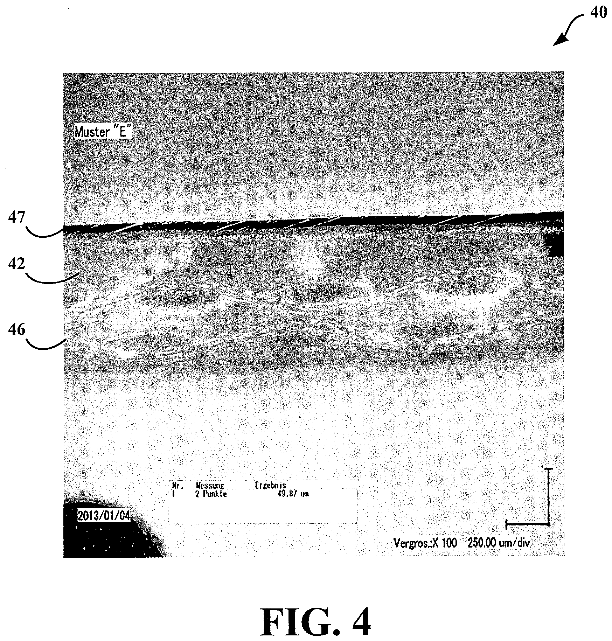

Figure 4 is a side cutaway view of a printed circuit board substrate (40) according to an exemplary embodiment including a base layer (42) being used as a bonding sheet between a copper foil layer (47), an innerlayer material (46) in the form of glass reinforced epoxy core material, and a protective layer (44) in the form of a prepreg;

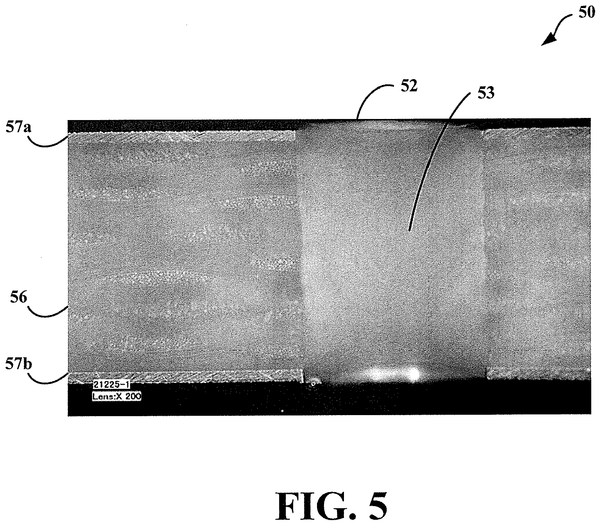

Figure 5 is side cutaway view of a printed circuit board substrate (50) according to an exemplary embodiment including a base layer (52) that has filled a via (53) between copper foil layers (57a, 57b) and an innerlayer material (56) in the form of glass reinforced epoxy core material; and

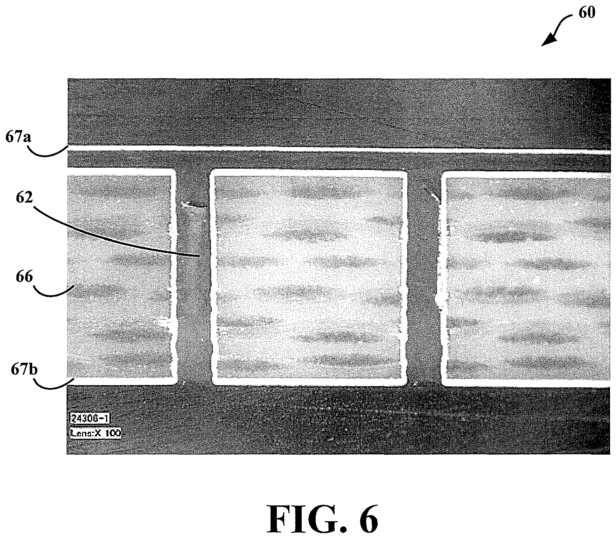

Figure 6 is side cutaway view of a printed circuit board substrate (60) according to an exemplary embodiment including a base layer (62) that has filled gaps between copper foil tracks (67a, 67b, 67c, 67d) and an innerlayer material (66) in the form of glass reinforced epoxy core material.

### DESCRIPTION OF THE CURRENT EMBODIMENTS

The present invention relates to resin film products comprising a base layer (12) that includes a resin film based on a variety of resin systems (e.g. epoxy, filled, unfilled, high Tg, mid Tg, thermal conductive, halogen free, brominated, etc.). The resin film is partially cured to a b-staged condition and is positioned between a first protective layer (14) (such as a first polyester film) and a second protective layer (16) (such as a second polyester film), as shown in Figure 1. The present invention also relates to methods of using the resin film products to manufacture layups that are used to produce printed circuit boards.

Figure 1A is a side view of a resin film product (10) of this invention including a base layer (12) containing a partially cured b-staged resin film, a first protective layer (14) and a second protective layer (16). The resin film products of this invention can be formed into individual sheets or into rolls from which sheets can subsequently be cut into a desired shape. In some example embodiments, the length and/or width of the first protective layer (14) and the second protective layer (16) extend further than the length and/or width of base layer (12). The sheets and rolls can have any useful dimensions from just a few inches to 3 or 4 feet or more in either or both the X and Y dimensions.

Alternatively, the resin film products may be rolled in such a manner that only one surface of base layer (12), such as second planar surface (13), would require a first protective layer (14). In an example configuration, first planar surface (11) of base layer (12), when unrolled, would remain exposed while second planar surface (13) of base layer (12) is protected by second protective layer (16). Then, when rolled, second protective layer (16) would act to protect both first planar surface (11) and second planar surface (13) of base layer (12).

Base layer (12), which contains a partially cured b-staged resin film, may be based on a number of different resin systems that are useful in conjunction with pre-impregnated composite fibers ("prepregs") and laminates used in the manufacture of printed circuit boards (PCBs). These resin systems may include, but are not limited to, epoxy, filled, unfilled, high Tg, mid Tg, thermally conductive, halogen free, and halogenated resin systems, among others.

The term "resin" is used in the context of this application to refer generally to any curable resin system that can be used now or in the future in the production of laminates used to manufacture printed circuit boards and other electronic applications. Most often, epoxy resins are used to make such laminates. The term "epoxy resin" refers generally to a curable composition of oxirane ring-containing compounds as described in C.A. May, Epoxy Resins, 2nd Edition, (New York & Basle: Marcel Dekker Inc.), 1988. One or more epoxy resins are added to a resin system in order to provide the desired basic mechanical and thermal properties of the cured resin and laminates made there from. Useful epoxy resins are those that are known to one of skill in the art to be used in resin systems that are useful for the manufacture of electronic composites and laminates.

In a preferred embodiment, the resin film is based upon an epoxy resin system. A variety of epoxy resins may be used. For example, the epoxy resin may be a phenol type epoxy resin, an amine type epoxy resin, a novolac type epoxy resin, and an aliphatic type epoxy resin. Other types of epoxy resins may be available as well. Some examples of useful epoxy resins include phenol type epoxy resins such as those based on the diglycidyl ether of bisphenol A, on polyglycidyl ethers of phenol-formaldehyde novolac or cresol-formaldehyde novolac, on the triglycidyl ether of tris(p-hydroxyphenol)methane, or on the tetraglycidyl ether of tetraphenylethane; amine types such as those based on tetraglycidyl-methylenedianiline or on the triglycidyl ether of p-aminoglycol; and cycloaliphatic types such as those based on 3,4-epoxycyclohexylmethyl-3,4-epoxycyclohexane carboxylate. The term "epoxy resin" also stands for reaction products of compounds containing an excess of epoxy (for instance, of the aforementioned types) and aromatic dihydroxy compounds. These compounds may be halogen-substituted. Preference is given to epoxy-resins which are a derivative of bisphenol A, particularly FR-4. FR-4 is made by an advancing reaction of an excess of bisphenol A diglydicyl ether with tetrabromobisphenol A. Mixtures of epoxy resins with bismaleimide resin, cyanate resin and/or bismaleimide triazine resin can also be applied.

In certain examples of the invention as described herein, base layer (12) may contain fillers, such as organic fillers. When fillers are used, they may be present in base layer (12) in an amount ranging from about 5% to 55% by weight of ingredients incorporated, on a solvent free or dry basis, in the resin system. In an alternative embodiment, the fillers may be present in base layer (12) in an amount ranging from about 15% to 40% by weight. In yet a further embodiment, the fillers may be present in base layer (12) in an amount ranging from about 25% to about 55% by weight. Additionally, base layer (12) may contain inorganic inert particulate fillers, such as magnesium hydroxide, magnesium silicate ("talcum" or "talc"), silica dioxide, and aluminum trihydrate. The amount of inorganic inert particulate fillers, such as talc, incorporated in base layer (12) may range from 5% to about 20% by weight. In further embodiments, base layer (12) may also include thermally conductive fillers and inorganic/organic fibers, such as boron nitride or aluminum nitride. These thermally conductive fillers are particularly useful in light-emitting diode (LED) technology as their presence eliminates the need for conductive insulators, thus lengthening the lifetime of LEDs. In yet a further embodiment, base layer (12) may include any combination of the aforementioned fillers.

Base layer (12) may also include initiators or catalysts, one or more optional flame retardants and solvents. The flame retardant may be any flame retardant material that is known to be useful in resin compositions used to manufacture prepregs and laminates used to manufacture printed circuit boards. The flame retardant(s) may contain halogens or they may be halogen free. Alternatively, or in addition, the resins may include halogens, such as bromine, in their backbone structure to impart the cured resin with flame retardant properties.

During the manufacture of base layer (12), one or more solvents that solubilize the appropriate resin composition ingredients, control resin viscosity, or maintain the resin ingredients in a suspended dispersion may be used. Any solvent known by one of skill in the art to be useful in conjunction with thermosetting resin systems can be used. Particularly useful solvents include methylethylketone, toluene, dimethylformamide, diisobutyl ketone, propylene glycol methyl ether, propylene glycol methyl ether acetate, propylene glycol n-butyl ether, or mixtures thereof. During the manufacturing process, these solvents may then be removed from the resin system in order to form base layer (12). Removal may occur through the use of heat, ultraviolet light, or infrared light. Thus, when base layer (12) weight percent amounts are listed herein, they are reported on a dry-solvent free-basis unless otherwise noted.

The resin compositions may also include polymerization initiators or catalysts. When catalysts are used, they may be present in base layer (12) in an amount ranging from about 0.05% to about 0.20% by weight. Examples of some useful initiators or catalysts include, but are not limited to peroxide or azo-type polymerization initiators. In general, the initiators or catalysts chosen may be any compound that is known to be useful in resin synthesis or curing whether or not it performs one of these functions.

The resin compositions may include a variety of other optional ingredients including fillers, tougheners, adhesion promoters, defoaming agents, leveling agents, dyes, and pigments. These optional ingredients, when used, may be present in base layer (12) in an amount ranging from 5% to about 10%. For example, a fluorescent dye can be added to the resin composition in a trace amount to cause a laminate prepared therefrom to fluoresce when exposed to UV light in a board shop's optical inspection equipment. Other optional ingredients known by persons of skill in the art to be useful in resins that are used to manufacture printed circuit board laminates may also be included in the resin compositions of this invention.

One embodiment of the disclosure is a base layer (12) comprising about 70% to about 90% by weight of a resin matrix, about 6% to about 10% by weight of a toughener, and about 5% to about 20% by weight of a filler.

In an example embodiment, base layer (12) was prepared from the following ingredients:

| **Ingredient** | % **Solids** |
|---|---|
| Epoxy resin and catalyst composition | 52.18% |
| Epoxy resin, supplied in solution | 3.64% |
| Carboxylated acrylonitrilebutadiene copolymer | 8.02% |
| Phenolic-Novolac Resin (67.5% solids) | 23.46% |
| 2-Phenyl Imidazole | 0.03% |
| Propylene glycol methyl ether | 0% |
| 10% Boric acid in MeOH | 0.06% |
| Boron trifluoride monoethylamine | 0.03% |
| Talc | 12.57% |

The thickness of base layer (12) can vary. In an example embodiment, the thickness of base layer (12), may range from about 0.1 mils to about 3 mils. In certain embodiments, the thickness may exceed 3 mils and can reach a thickness of 13 mils. In an example embodiment, the thickness of base layer (12) may range from 0.1 mils to 1 mils. In yet a further embodiment, the thickness of base layer (12) may range from about 1 mils to 2 mils. Finally, in a further embodiment, the thickness of base layer (12) may range from about 2 mils to about 3 mils. In a preferred embodiment, the thickness of the resin film is 1, 2, or 3 mils. The viscosity of base layer (12) when heated can also be controlled, particularly based on the thickness of the resin film. Generally, the viscosity of base layer (12) should increase as the thickness of base layer (12) increases.

As discussed above, protective layers (14, 16) are associated with first planar surface (11) and second planar surface (13) of base layer (12). The first protective layer (14) and second protective layer (16) may be the same or different type of sheet material. In certain embodiments, the protective layers (14, 16) are preferably an inexpensive disposable material that protects base layer (12) from damage, contamination, and further crosslinking.

In an example embodiment, the protective layers (14, 16) are comprised of a polyester sheet or material. In yet a further example embodiment, the first protective layer (14) or the second protective layer (16) can be a metal foil. For example, the protective layers (14, 16) may be composed of a copper foil, an aluminum foil, a tin foil, or a gold foil, or mixtures thereof. One of ordinary skill in the art will appreciate that other metal and non-metal foils may be available as well. Further, other polymeric or sheet materials, such as polymer coated or impregnated paper sheets, and reinforced fabric that has been pre-impregnated with a resin system ("prepreg"), are available. In a preferred embodiment, either one or both of the protective layers (14, 16) is comprised of polyethylene terephthalate (PET). For example, a biaxially oriented film made of polyethylene terephthalate, such as Hostaphan^{®}, may be used. In yet a further embodiment, the first protective layer (14) may be composed of a polyester sheet while the second protective layer (16) may be a metal foil. Other combinations are available as well.

The thickness of the protective layers (14, 16) may vary. For example, in one embodiment, the thickness of the first protective layer (14) and/or the second protective layer (16) may range from about 1 mils to about 5 mils, or more. In an example embodiment, where the material used to form the protective layers (14, 16) is a polyester sheet or film, the thickness may range from about 3 mils to 4 mils. The thickness of the first protective layer (14) and/or the second protective layer (16) may be greater than or less than the thickness of base layer (12). Further, the thickness of the protective layers (14, 16) may differ from each other.

The materials that protective layers (14, 16) are comprised of may be selected from materials that may be easily removed from base layer (12) without causing damage to first planar surface (11) and/or second planar surface (13). In a further embodiment, either the first protective layer (14) or the second protective layer (16) may be a non-removable material such as a "prepreg," which is a reinforced fabric that has been pre-impregnated with a b-staged resin system. The prepreg may include woven or non-woven reinforcements such as fiberglass, carbon fiber, and aramid, among others, that are impregnated with resin. Also, the prepreg may be a thermoset prepreg or a thermoplastic prepreg. For example, the thermoset prepreg may include a primary resin matrix, such as epoxy, which fully impregnates a fiber reinforcement system, such as glass cloth. The resin may be cured, to create a fully cured resin backing layer, or partially cured, to create a solidified prepreg sheet. Other polymeric materials or sheet materials, including polymer coated or impregnated paper sheets, may also be used.

The resin film product (10), which includes a base layer (12), a first protective layer (14), and an optional second protective layer (16) as described above, can be manufactured in batch or in continuous processes. In an example embodiment, base layer (12) may be formed and b-staged before uniting it with first protective layer (14) and/or second protective layer (16). Base layer (12) may be prepared using a variety of methods understood by those of ordinary skill in the art. For example, base layer (12) may be formed by combining the desired resin ingredients, such as those described above, with a solvent to form a resin system. Then, the resin system may be partially cured to a b-staged condition to form base layer (12) through the use of heat, infrared light, or ultraviolet light. In one embodiment, solvent in the range of about 0.5% to about 3% may remain in base layer (12) when partially cured to a b-staged condition. Finally, the protective layers (14, 16) may be applied. Other curing methods may be available as well. Partial curing may be advantageous as it causes base layer (12), when cooled, to be non-viscous and not tacky to the touch.

In an alternative embodiment, base layer (12) may be formed and b-staged after uniting it with first protective layer (14) or second protective layer (16). For example, base layer (12) may be formed by combining the desired resin ingredients with a solvent to form a resin system. Then, the resin system may be applied in a controlled thickness to a surface of either the first protective layer (14) or the second protective layer (16) using slot-die or other related coating techniques. Then the resin system may be partially cured to a b-staged condition to form base layer (12). Finally, the remaining protective layer (14, 16) may be applied on the exposed surface of base layer (12).

In one exemplary process for manufacturing resin film product (10), a thin layer of the resin system may be applied to the surface of first protective layer (14) that is being continuously unwound from a drive role in order to form base layer (12). The combined base layer (12) and first protective layer (14) then travel through a curing station at which heat or light is directed at base layer (12) to remove the majority of solvent from base layer (12) such that base layer (12) contains 0.5% to about 3% by weight of solvent, thus rendering base layer (12) partially cured in a "B" stage. Once base layer (12) has been partially cured, a second protective layer (16) may be applied to the exposed planar surface of base layer (12), thus eliminating any opportunity for dust or other materials to contaminate the surfaces of base layer (12). In one embodiment, the material used as the second protective layer was a prepreg.

Another aspect of the invention is the use of resin film products (10) in the production of layups that are used in the manufacture of printed circuit boards. Specifically, base layer (12) may be used for heavy copper filling, via filling, as a bonding film, or as a high thermal conductive bonding film for printed circuit boards.

As illustrated in Figure 1, a resin film product (10) of this invention is formed. The resin film product includes a base layer (12) which is comprised of a b-staged resin film, has a thickness of, for example, between 1 mil and 10 mils, and may not be tacky to the touch at room temperature. Base layer (12) is disposed between first protective layer (14) and second protective layer (16).

In certain embodiments, resin film product (10) is cut into desired shapes or geometries in order to cover selected components located on a printed circuit board. When cutting the resin film product, the presence of protective layers (14, 16) surrounding base layer (10) inhibits the emission of dust, breakage of base layer (12), or risk of contamination of base layer (12) by foreign materials. Protective layers (14, 16) also provide for safe and convenient handling of base layer (12).

Once the resin film product is cut or formed to the desired shape, base layer (12) may be applied to a circuit board substrate, such as an innerlayer material surface, which may or may not include one or more three-dimensional features such as gaps, vias, circuits, traces, and/or other electronic components. In certain embodiments, the innerlayer material may be comprised of a glass reinforced epoxy core material, such as a multi-layered prepreg.

In an example embodiment, the one or more three-dimensional features located on the innerlayer material surface of the circuit board substrate may include copper foil traces made from copper foils that range from about 0.5 oz to 12 oz. The thickness of the copper foil traces varies based on the weight of the copper foil used to form them. For example, a 1 oz copper foil has a thickness of 35 microns, a 10 oz copper foil has a thickness of 350 microns, and a 12 oz copper foil has a thickness of 400 microns. Other weights and thicknesses may be available as well. Generally, heavier copper foils, and thus a thicker copper foil traces, provide for better temperature control of the printed circuit boards. Other types of electronic components located on the innerlayer material surface of the circuit board substrate may be used as well.

When manufacturing circuits onto an innerlayer material surface of a circuit board, three-dimensional features, such as gaps or vias, may also form in locations where copper is removed. For example, a gap (23) is illustrated in Fig. 2A. One use of base layer (12) of this invention is to apply base layer (12) to the innerlayer material in order to fill and/or cover gaps, vias, or any other type of three-dimensional feature located on the surface of the innerlayer material of the circuit board substrate (28).

As shown in Figure 2A, in order to adhere base layer (12) to the innerlayer material surface of the circuit board substrate (28), either first protective layer (14) or second protective layer (16) may be removed from base layer (12) to expose an unprotected surface of base layer (12). This step, in an example embodiment, may occur just before applying the resin film product (20) to the printed circuit board substrate (28). This keeps the material clean and free of contamination.

As shown in Figure 2B, the resin film product (22) may be positioned over and applied to the exposed innerlayer material surface of the printed circuit board substrate (28). To ensure that base layer (12) adheres to the innerlayer material surface of the printed circuit board substrate (28), the innerlayer material surface may be warmed up sufficiently to cause base layer (12) to liquefy and become tacky when it is applied to the printed circuit board substrate. Heating the innerlayer material surface to a temperature of about 40 to 90°C and preferably 50 to 60°C is suggested. Further, pressure may be applied to the resin film product in order to ensure adherence to the printed circuit board substrate.

As shown in Figure 2C, the warmed innerlayer material of the circuit board substrate (28) liquefies the b-staged resin from base layer (12) and causes it to flow and adhere to the innerlayer material surface. The liquefied b-staged resin from the base layer (12) also may cover and fill gaps (23), vias, and other three-dimensional features that are located on the innerlayer material surface of printed circuit board substrate (28). The gaps, vias, or other three-dimensional features may be substantially filled such that 90% or more of the void three-dimensional space is filled by the flowing base layer resin. Once the flowing base layer resin fills the gaps, vias, or three-dimensional features, they are essentially void free. Likewise, the electronic components may be substantially covered, such that sections of the electronic components are not exposed. The remaining protective layer (14), or a prepreg, may remain on the base layer (12). The resulting layup is allowed to cool down to room temperature at which point the base layer (12) remains adhered to the innerlayer surface but no longer is tacky to the touch.

When heated, the flow of the base layer resin may be aided by applying pressure to base layer (12) as it is being adhered to the innerlayer material surface of the circuit board substrate (28). For example, applying more pressure to base layer (12) may cause the flow of the base layer resin to increase. Likewise, the flow of the base layer resin may be aided by heating base layer (12) from above. For example, hot air may be directed towards base layer (12) in order to warm the base layer resin, thus increasing the flow. In certain embodiments, all heat is applied to base layer (12) from above.

As shown in Figure 2D, the remaining protective layer on the base layer (12) may remain or be removed, leaving a specially cut non-tacky b-staged resin layer adhered to the circuit board substrate (28). In a preferred embodiment, the base layer (12), once adhered, creates a planar surface, known as a "butter layer" (27), to which subsequent layers may be adhered. The thickness of the "butter layer" may vary, but should be thick enough to act as a dividing layer between any material subsequently adhered to the planar surface of base layer (12), such as a prepreg, and the circuit board substrate (28), particularly the copper tracks. For example, a bonding sheet may be applied to the newly exposed surface of base layer (12), or the top planar surface of the "butter layer," such that the bonding sheet does not have contact with the circuit board substrate. In further embodiments, base layer (12) may be used as a bonding sheet, where no gaps or vias are present.

Examples of the use of the resin film products in printed circuit board substrates are illustrated in Figures 3-6.

For example, Figure 3 is a side cutaway view of a printed circuit board substrate (30) which includes a partially cured b-staged base layer (32) being used to fill a via that is located between copper tracks (37c, 37d). An innerlayer material (36) in the form of glass reinforced epoxy core material is located between the copper tracks (37a, 37b, 37c, 37d). Finally, a protective layer (34) in the form of a reinforced fabric pre-impregnated with a resin system is adhered to the surface of the base layer.

Figure 4 is a side cutaway view of a printed circuit board substrate (40) which includes a base layer (42) being used as a bonding sheet between a copper foil layer (47), an innerlayer material (46) in the form of glass reinforced epoxy core material, and a protective layer (44) in the form of a prepreg. Base layer (42) may also be used to fill any gaps or vias created in the printed circuit board substrate. The base layer (42) may be further cured by "C"-staging the "B"-staged resin base layer from the resin film product as described herein.

Figure 5 is a side cutaway view of a printed circuit board substrate (50) according which includes a partially cured b-staged base layer (52) being used to fill a via between copper foil layers (57a, 57b). Likewise, an innerlayer material (56) in the form of glass reinforced epoxy core material is sandwiched in between the two copper foil layers. The via may be created during the formation of copper circuits on the printed circuit board substrate. Once the partially cured "B"-staged base layer (52) fills the via, it may be subsequently fully cured or "C"-staged.

Finally, in Figure 6, a side cutaway view of a printed circuit board substrate (60) is illustrated. The printed circuit board substrate (60) includes a partially cured b-staged base layer (62) being used to fill gaps between copper foil tracks (67a, 67b) and an innerlayer material (66) in the form of glass reinforced epoxy core material. Similar to the examples noted above, the partially cured "B"-staged resin base layer (62) may be subsequently fully cured or "C"-staged once the gaps or vias in the printed circuit board substrate have been filled.

## Claims

1. A resin film product (10) comprising:
a b-staged resin base layer (12) having a first planar surface (11) and a second planar surface (13), wherein the base layer (12) has a thickness of 25.4µm (1 mil) to 254µm (10 mils);
a first protective layer (14) disposed on the first planar surface (11) of the base layer (12); and
a second protective layer (16) disposed on the second planar surface (16) of the base layer (12);
wherein the first protective layer (14) and the second protective layer (16) are comprised of a biaxially oriented polyethylene terephthalate with a thickness of 25.4µm (1 mil) to 127µm (5 mils) and are configured to be separable from the base layer (12).

2. The resin film product (10) of claim 1, wherein the base layer (12) is made from resin that includes a toughener.

3. The resin film product (10) of any preceding claim, wherein the base layer (12) has a thickness of 25.4µm (1 mil) to 76.2µm (3 mils).

4. The resin film product (10) of any preceding claim, wherein the base layer (12) is made from resin that includes a filler material.

5. The resin film product (10) of claim 4 wherein the filler material is talc.

6. A method comprising the steps including:
providing a resin film product (10) according to claim 1;
heating an exposed innerlayer material surface of a printed circuit board substrate (28);
removing the second protective layer (16) from the second planar surface (13) of the base layer (12);
applying the second planar surface (13) of the base layer (12) against the heated exposed innerlayer material surface of the printed circuit board substrate (28) to form a printed circuit board layup (24); and
cooling the printed circuit board layup (24).

7. The method of claim 6, further comprising the step of removing the first protective layer (14) disposed on the first planar surface (11) of the base layer (12) after applying the second planar surface (13) of the base layer (12) against the heated exposed innerlayer material surface of the printed circuit board substrate (28).

8. The method of claim 7, further comprising the step of adhering a bonding sheet to the first planar surface (11) after applying the unprotected second planar surface (13) of the base layer (12) to the heated exposed innerlayer material surface of the printed circuit board substrate (28).

9. The method of claim 8 wherein the bonding sheet is a prepreg material.

10. The method of claim 6, wherein the innerlayer material surface of the printed circuit board substrate (28) is heated to a temperature ranging from 40°C to 90°C or 50°C to 60°C.

11. The method of claim 6, wherein the application of the second planar surface (13) of the base layer (12) to the heated exposed innerlayer material surface of the printed circuit board substrate (28) is performed using pressure.

12. The method of claim 6, further comprising the step of filling at least one gap (23) located in the printed circuit board substrate (28) with the base layer (12), wherein the step of filling at least one gap (23) occurs after applying the uncovered second planar surface (13) of the base layer (12) to the heated innerlayer material surface of the printed circuit board substrate (28).

13. The method of claim 6, further comprising the step of fully curing the resin film to a "C" staged condition.

## Patentansprüche

1. Kunstharzfolienprodukt (10), umfassend:
eine b-stufige Kunstharzbasisschicht (12), die eine erste ebene Fläche (11) und eine zweite ebene Fläche (13) aufweist, wobei die Basisschicht (12) eine Dicke von 25,4 µm (1 mil) bis 254 µm (10 mil) aufweist;
eine erste Schutzschicht (14), die auf der ersten ebenen Fläche (11) der Basisschicht (12) angeordnet ist; und
eine zweite Schutzschicht (16), die auf der zweiten ebenen Fläche (16) der Basisschicht (12) angeordnet ist;
wobei die erste Schutzschicht (14) und die zweite Schutzschicht (16) ein biaxial ausgerichtetes Polyethylenterephthalat mit einer Dicke von 25,4 µm (1 mil) bis 127 µm (5 mil) umfassen und
dazu konfiguriert sind, von der Basisschicht (12) abtrennbar zu sein.

2. Kunstharzfolienprodukt (10) nach Anspruch 1, wobei die Basisschicht (12) aus einem Kunstharz hergestellt ist, das einen Zähigkeitsverstärker beinhaltet.

3. Kunstharzfolienprodukt (10) nach einem der vorstehenden Ansprüche, wobei die Basisschicht (12) eine Dicke von 25,4 µm (1 mil) bis 76,2 µm (3 mil) aufweist.

4. Kunstharzfolienprodukt (10) nach einem der vorstehenden Ansprüche, wobei die Basisschicht (12) aus Kunstharz hergestellt ist, das ein Füllmaterial beinhaltet.

5. Kunstharzfolienprodukt (10) nach Anspruch 4, wobei das Füllmaterial Talkum ist.

6. Verfahren, umfassend die folgenden Schritte:
Bereitstellen eines Kunstharzfilmprodukts (10) nach Anspruch 1;
Erhitzen einer freiliegenden Innenschichtmaterialfläche eines Leiterplatinensubstrats (28);
Entfernen der zweiten Schutzschicht (16) von der zweiten ebenen Fläche (13) der Basisschicht (12);
Auftragen der zweiten ebenen Fläche (13) der Basisschicht (12) auf die erhitzte freiliegende Innenschichtmaterialfläche des Leiterplatinensubstrats (28), um ein Layup (24) einer Leiterplatine zu bilden; und
Abkühlen des Layups (24) einer Leiterplatine.

7. Verfahren nach Anspruch 6, ferner umfassend den Schritt eines Entfernens der ersten Schutzschicht (14), die auf der ersten ebenen Fläche (11) der Basisschicht (12) angeordnet ist, nachdem die zweite ebene Fläche (13) der Basisschicht (12) auf die erhitzte freiliegende Innenschichtmaterialfläche des Leiterplatinensubstrats (28) aufgetragen wurde.

8. Verfahren nach Anspruch 7, ferner umfassend den Schritt eines Klebens einer Haftbahn an die erste ebene Fläche (11), nachdem die ungeschützte zweite ebene Fläche (13) der Basisschicht (12) auf die erhitzte freiliegende Innenschichtmaterialfläche des Leiterplatinensubstrats (28) aufgetragen wurde.

9. Verfahren nach Anspruch 8, wobei die Haftbahn ein Prepreg-Material ist.

10. Verfahren nach Anspruch 6, wobei die Innenschichtmaterialfläche des Leiterplatinensubstrats (28) auf eine Temperatur von 40 °C bis 90 °C oder von 50 °C bis 60 °C erhitzt wird.

11. Verfahren nach Anspruch 6, wobei das Auftragen der zweiten ebenen Schicht (13) der Basisschicht (12) auf die erhitzte freiliegende Innenschichtmaterialfläche des Leiterplatinensubstrats (28) mithilfe von Druck durchgeführt wird.

12. Verfahren nach Anspruch 6, ferner umfassend den Schritt eines Füllens von mindestens einer Lücke (23), die sich in dem Leiterplatinensubstrat (28) befindet, mit der Basisschicht (12), wobei der Schritt des Füllens mindestens einer Lücke (23) stattfindet, nachdem die unbedeckte zweite ebene Fläche (13) der Basisschicht (12) auf die erhitzte Innenschichtmaterialfläche des Leiterplatinensubstrats (28) aufgetragen wurde.

13. Verfahren nach Anspruch 6, ferner umfassend den Schritt eines vollständigen Aushärtens der Kunstharzfolie auf eine C-stufige Bedingung.

## Revendications

1. Produit de film de résine (10) comprenant :
une couche de base en résine de stade b (12) ayant une première surface plane (11) et une seconde surface plane (13), dans lequel la couche de base (12) a une épaisseur de 25,4 µm (1 millième de pouce) à 254 µm (10 millièmes de pouce) ;
une première couche protectrice (14) disposée sur la première surface plane (11) de la couche de base (12) ; et
une seconde couche protectrice (16) disposée sur la seconde surface plane (16) de la couche de base (12) ;
dans lequel la première couche protectrice (14) et la seconde couche protectrice (16) sont constituées d'un téréphtalate de polyéthylène orienté biaxialement d'une épaisseur de 25,4 µm (1 millième de pouce) à 127 µm (5 millièmes de pouce) et sont conçues pour pouvoir être séparées de la couche de base (12).

2. Produit de film de résine (10) selon la revendication 1, dans lequel la couche de base (12) est fabriquée à partir d'une résine qui comporte un durcisseur.

3. Produit de film de résine (10) selon une quelconque revendication précédente, dans lequel la couche de base (12) a une épaisseur de 25,4 µm (1 millième de pouce) à 76,2 µm (3 millièmes de pouce).

4. Produit de film de résine (10) selon une quelconque revendication précédente, dans lequel la couche de base (12) est fabriquée à partir d'une résine qui comporte un matériau de remplissage.

5. Produit de film de résine (10) selon la revendication 4, dans lequel le matériau de remplissage est le talc.

6. Procédé comprenant les étapes comportant :
la fourniture d'un produit de film de résine (10) selon la revendication 1 ;
le chauffage d'une surface de matériau de couche interne exposée d'un substrat de carte de circuit imprimé (28) ;
le retrait de la seconde couche protectrice (16) de la seconde surface plane (13) de la couche de base (12) ;
l'application de la seconde surface plane (13) de la couche de base (12) contre la surface de matériau de couche interne exposée chauffée du substrat de carte de circuit imprimé (28) pour former un empilement de cartes de circuit imprimé (24) ; et
le refroidissement de l'empilement de cartes de circuit imprimé (24) .

7. Procédé selon la revendication 6, comprenant en outre l'étape de retrait de la première couche protectrice (14) disposée sur la première surface plane (11) de la couche de base (12) après l'application de la seconde surface plane (13) de la couche de base (12) contre la surface de matériau de couche interne exposée chauffée du substrat de carte de circuit imprimé (28) .

8. Procédé selon la revendication 7, comprenant en outre l'étape de collage d'une feuille de liaison à la première surface plane (11) après l'application de la seconde surface plane (13) non protégée de la couche de base (12) à la surface de matériau de couche interne exposée chauffée du substrat de carte de circuit imprimé (28).

9. Procédé selon la revendication 8, dans lequel la feuille de liaison est un matériau préimprégné.

10. Procédé selon la revendication 6, dans lequel la surface de matériau de couche interne du substrat de carte de circuit imprimé (28) est chauffée à une température allant de 40 °C à 90 °C ou de 50 °C à 60 °C.

11. Procédé selon la revendication 6, dans lequel l'application de la seconde surface plane (13) de la couche de base (12) à la surface de matériau de couche interne exposée chauffée du substrat de carte de circuit imprimé (28) est effectuée à l'aide d'une pression.

12. Procédé selon la revendication 6, comprenant en outre l'étape de remplissage d'au moins un espace (23) situé dans le substrat de carte de circuit imprimé (28) avec la couche de base (12), dans lequel l'étape de remplissage d'au moins un espace (23) se produit après l'application de la seconde surface plane (13) non recouverte de la couche de base (12) à la surface de matériau de couche interne chauffée du substrat de carte de circuit imprimé (28).

13. Procédé selon la revendication 6, comprenant en outre l'étape de durcissement complet du film de résine à un état de stade « C ».
